# FASCICULE DE BREVET EUROPEEN

(11) **EP 3 990 961 B1**
(45) Date de publication et mention de la délivrance du brevet: **31.07.2024**
(21) Numéro de dépôt: 20733377.4
(22) Date de dépôt: 08.06.2020
(51) Int. Cl.: G02B 19/00, F21S 41/00, G02B 26/08, G02B 27/62, H05K 3/30, F21S 41/39, F21S 41/675

(54) **MODULE OPTIQUE COMPRENANT UNE MATRICE DE MICRO-MIROIRS**
OPTISCHES MODUL MIT MIKROSPIEGELANORDNUNG
OPTICAL MODULE COMPRISING A MICRO-MIRROR ARRAY

(30) Priorité: 28.06.2019 FR 1907195
(43) Date de publication de la demande: 04.05.2022
(73) Titulaire: Valeo Vision, 93012 Bobigny Cedex (FR)
(72) Inventeur: ROUSSEAU, Maxime, 93012 BOBIGNY Cedex (FR)
(74) Mandataire: Valeo Visibility
(86) Numéro de dépôt international: PCT/EP2020/065882
(87) Numéro de publication internationale: WO 2020/260001

(56) Documents cités:
- JP-B2- 6 011 667
- US-A1- 2004 150 083
- US-A1- 2011 261 537
- US-A1- 2016 118 731
- US-A1- 2018 320 718

## Description

### Domaine Technique de l'invention

L'invention concerne un module optique, notamment un module optique équipé d'une matrice de micro-miroirs. L'invention porte aussi sur un procédé de fabrication d'un tel module optique. L'invention porte encore sur un projecteur pour véhicule automobile comprenant un tel module optique.

### Etat de la technique antérieure

Pour l'éclairage des véhicules automobiles, on connaît l'utilisation de projecteurs comprenant un module optique équipé d'une source lumineuse et d'une puce équipée d'une matrice de micro-miroirs. Une matrice de micro-miroirs est un microsystème électromécanique comprenant une multitude de micro-miroirs qui sont tous mobiles autour d'un axe et qui peuvent prendre au moins deux orientations distinctes. Selon une première orientation, un micro-miroir transmet un rayon lumineux hors du module optique, dans un champ d'éclairage. Selon une deuxième orientation, le rayon lumineux est dévié hors du champ d'éclairage. L'orientation de chaque micro-miroir peut être commandée individuellement par l'effet d'une force électrostatique. A cet effet, le module optique comprend une unité de commande électronique. La puce comprenant la matrice de micro-miroirs est fixée sur une carte électronique reliée à l'unité de commande électronique. L'unité de commande électronique émet un courant de commande via la carte électronique à destination de chacun des micro-miroirs pour définir leur orientation.

De tels modules optiques permettent de composer et de projeter des images complexes devant le véhicule. Ils sont donc utilisés pour réaliser différentes fonctions telles que par exemple la projection d'informations utiles à la sécurité de piétons situés aux abords directs du véhicule, ou encore par exemple une fonction d'éclairage de la route évitant l'éblouissement des autres automobilistes. Les images produites par le module optique doivent donc être nettes et correctement positionnées dans l'espace.

Par ailleurs, la carte électronique sur laquelle est fixée la puce doit également être maintenue. La carte électronique est généralement fixée à un boîtier ou à un support du module optique. La position et l'orientation de la matrice de micro-miroirs sont donc affectées par les tolérances de fabrication de la carte électronique, par les tolérances d'assemblage de la puce sur la carte électronique et enfin par les tolérances d'assemblage de la carte électronique au boîtier. La matrice de micro-miroirs n'est donc pas toujours positionnée avec précision par rapport à la source lumineuse. Il s'en suit que les images produites par le module optique n'ont pas toujours la netteté et/ou la précision requises.

Les documents JP6011667B2 et US2004/150083A1 divulguent des modules optiques où une carte électronique ayant une puce électronique est fixée sur un support.

### Présentation de l'invention

Le but de l'invention est de fournir un module optique et un procédé de fabrication d'un tel module optique remédiant aux inconvénients ci-dessus et améliorant les modules optiques et les procédés de fabrication connus de l'art antérieur.

Plus précisément, un premier objet de l'invention est un module optique permettant un positionnement et une orientation précise d'une matrice de micro-miroirs.

Un second objet de l'invention est un module optique dans lequel la carte électronique est fixée sans contrainte ni déformation.

Un troisième objet de l'invention est un module optique simple à fabriquer.

### Résumé de l'invention

L'invention a ainsi pour objet un module optique remarquable en ce qu'il comprend un support, une carte électronique, une puce électronique munie d'une matrice de micro-miroirs, et au moins une cale, la puce étant fixée à la carte électronique, le support comprenant une première surface en appui contre la puce et une deuxième surface en appui contre l'au moins une cale, la deuxième surface du support étant inclinée par rapport à la première surface du support, l'au moins une cale étant en appui contre la carte électronique.

Selon l'invention, le module comprend au moins une deuxième cale, et le support comprend une troisième surface en appui contre l'au moins deuxième cale, la troisième surface du support étant inclinée par rapport à la première surface du support, l'au moins deuxième cale étant en appui contre la carte électronique.

Selon une variante préférée, la première surface du support est sensiblement positionnée entre la deuxième surface du support et la troisième surface du support.

Selon l'invention, le module comprend au moins une vis de fixation passant au travers de la carte électronique, de l'au moins une cale et du support, de sorte à bloquer en position la cale par rapport au support.

Avantageusement, le support comprend un moyen d'indexation de la position de la puce par rapport au support, et/ou en ce que le support comprend une butée agencée à une extrémité de la deuxième surface du support, la butée étant apte à empêcher un glissement de l'au moins une cale hors de la deuxième surface du support.

Selon une variante préférée, la carte électronique s'étend selon un plan sensiblement parallèle à la première surface du support.

L'invention a également pour objet un projecteur pour un véhicule automobile, comprenant au moins une source de lumière et un module optique tel que défini ci-dessus.

L'invention a enfin pour objet un procédé de fabrication d'un module optique tel que défini ci-dessus, remarquable en ce qu'il comprend :
- une étape de positionnement de l'au moins une cale en appui contre la deuxième surface du support,
- une étape de positionnement de la puce en appui contre la première surface du support, la puce ayant été préalablement fixée à la carte électronique,
- une étape de déplacement de l'au moins une cale le long de la deuxième surface du support jusqu'à ce que l'au moins une cale prenne appui contre la carte électronique.

Le procédé peut en outre comprendre une étape additionnelle de vissage d'une vis de fixation au travers de la carte électronique, de l'au moins une cale et du support, de sorte à bloquer en position l'au moins une cale par rapport au support.

Avantageusement, le procédé comprend une étape de compression de la puce contre le support lors de l'étape de déplacement de l'au moins une cale le long de la deuxième surface du support, et éventuellement lors de l'étape de vissage de la vis de fixation.

De manière préférée, le procédé comprend une étape de positionnement d'une pièce d'outillage contre la carte électronique, de sorte à empêcher une déformation de la carte électronique sous l'effet d'un appui de l'au moins une cale contre la carte électronique, lors de l'étape de déplacement de l'au moins une cale le long de la deuxième surface du support, et éventuellement lors de l'étape de vissage de la vis de fixation.

### Présentation des figures

Ces objets, caractéristiques et avantages de la présente invention seront exposés en détail dans la description suivante d'un mode de réalisation particulier fait à titre non-limitatif en relation avec les figures jointes parmi lesquelles :
[Fig. 1] La figure 1 est une vue schématique d'un projecteur pour véhicule automobile équipé d'un module optique selon un mode de réalisation de l'invention.
[Fig. 2] La figure 2 est une vue schématique partielle d'un support et d'une cale du module optique.
[Fig. 3A] La figure 3A est une vue schématique d'une première étape d'un procédé de fabrication d'un module optique selon un mode de réalisation de l'invention.
[Fig. 3B] La figure 3B est une vue schématique d'une deuxième étape du procédé de fabrication.
[Fig. 3C] La figure 3C est une vue schématique d'une troisième étape du procédé de fabrication.
[Fig. 3D] La figure 3D est une vue schématique d'une quatrième étape du procédé de fabrication.
[Fig. 3E] La figure 3E est une vue schématique d'une cinquième étape du procédé de fabrication.

### Description détaillée

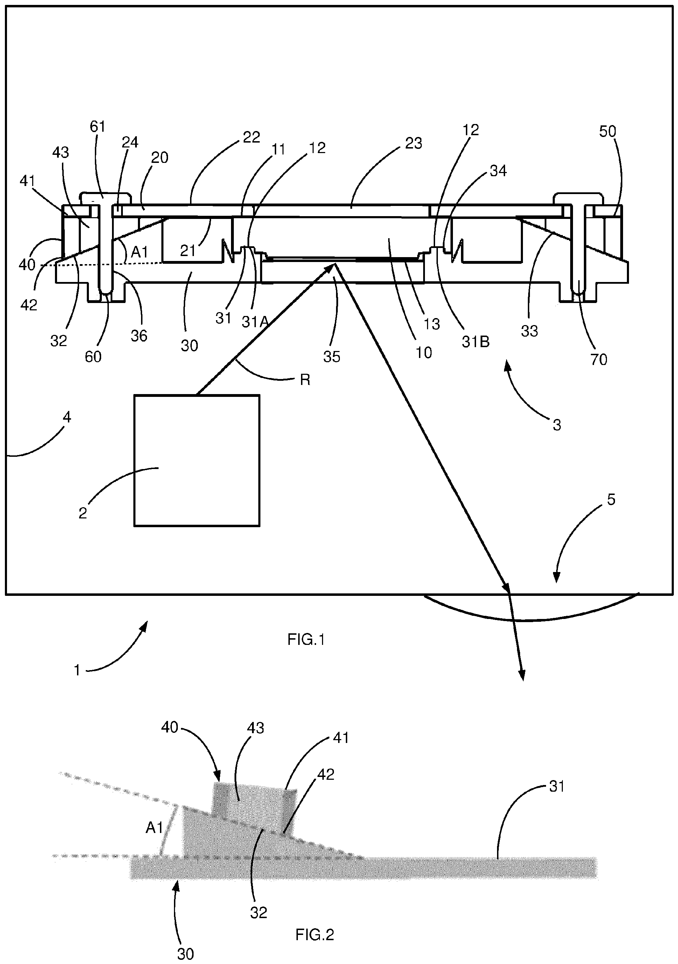

La figure 1 illustre schématiquement un projecteur 1 selon un mode de réalisation de l'invention. Le projecteur 1 est un dispositif lumineux pour un véhicule automobile. Il est apte à projeter une image lumineuse sur une scène environnant le véhicule.

Notamment, il permet d'éclairer l'environnement du véhicule et de rendre le véhicule visible pour les autres utilisateurs de la route. Le projecteur 1 peut être un projecteur avant ou un projecteur arrière du véhicule. Le projecteur 1 comprend une source de lumière 2 et un module optique 3 selon un mode de réalisation de l'invention. La source de lumière 2 et le module optique 3 sont fixés dans un boîtier 4 du projecteur destiné à être fixé au véhicule. Le projecteur comprend en outre un système optique de projection 5 apte à mettre en forme un faisceau lumineux.

La source de lumière 2 peut être de toute nature, notamment, elle peut comprendre une ou plusieurs diodes électroluminescentes et/ou une ampoule à incandescence et/ou toute autre source de lumière équivalente. Le boîtier 4 est une structure supportant les différents éléments du projecteur 1. Le boîtier peut notamment supporter la source de lumière 2, le module optique 3, et le système optique de projection 5. Le boîtier peut également comprendre un ou plusieurs moyens de fixation pour sa fixation à un véhicule. Le système optique de projection 5 peut comprendre un ensemble d'une ou plusieurs lentilles optiques transparentes, translucides ou réfléchissantes. Le système optique de projection est apte à être traversé par des rayons lumineux R issus de la source de lumière. La position relative de la source de lumière 2, du module optique 3 et du système de projection 5 doit être très précise pour obtenir des images nettes.

Le module optique 3 comprend une puce 10, une carte électronique 20, un support 30, une première cale 40 et une deuxième cale 50.

La puce 10 est un composant électronique, fixé et connecté électriquement à la carte électronique 20. La puce 10 peut avoir une forme globalement carrée ou rectangulaire. La puce comprend une première face ou surface 11 par laquelle elle est en appui contre la carte électronique 20, et une deuxième face ou surface 12 par laquelle elle est en appui contre le support 30. La première surface 11 est opposée à la deuxième surface 32. La deuxième surface 12 de la puce 10 fait saillie de la carte électronique en direction du support.

La puce 10 comprend une matrice de micro-miroirs 13. La matrice de micro-miroirs 13 est un microsystème électromécanique comprenant une multitude de micro-miroirs plats qui sont tous mobiles indépendamment autour d'un axe. Chaque micro-miroir peut prendre deux orientations distinctes : une orientation dite « active » et une orientation dite « inactive ». L'orientation de chaque micro-miroir peut être commandée individuellement par l'effet d'une force électrostatique. La matrice de micro-miroirs peut comprendre plusieurs centaines de micro-miroirs sur la largeur et plusieurs centaines de micro-miroirs sur la longueur. La matrice de micro-miroirs 13 est intégrée à la puce 10 de plus grande dimension. Notamment, la matrice de micro-miroirs est agencée sur la deuxième surface 12 de la puce 10. La source de lumière 2 est agencée de manière à pouvoir projeter des rayons lumineux R sur la matrice de micro-miroirs. Les rayons lumineux réfléchis par des micro-miroirs en orientation active peuvent traverser le système optique de projection 5 pour contribuer utilement à une fonction d'éclairage. Les rayons lumineux réfléchis par des micro-miroirs en orientation inactive sont réfléchis vers une zone non fonctionnelle du projecteur et peuvent être dissipés sous forme de chaleur.

Avantageusement, le module optique peut comprendre un dissipateur thermique (non représenté) apte à évacuer la chaleur emmagasinée par la matrice de micro-miroirs en raison du rayonnement lumineux qu'elle subit. Le dissipateur thermique peut être en contact direct avec la puce. Le dissipateur thermique peut être monté en appui sur une partie de la première surface 11 de la puce 10. A cet effet, la carte électronique 20 peut justement comprendre une ouverture 23 positionnée en vis-à-vis de la première surface 11 de la puce. Le dissipateur thermique s'étend alors au travers de cette ouverture. Il peut également s'étendre du côté de la carte électronique opposé au coté sur lequel est fixé la puce.

La carte électronique 20 est une carte de circuit imprimé (également dénommée PCB) s'étendant selon un plan. Elle peut avoir une forme quelconque, par exemple une forme globalement rectangulaire. Elle peut comprendre des composants électroniques autres que la puce 10, et des pistes électriques permettant de relier les composants électroniques entre eux. Elle peut également comprendre une connectique permettant de connecter la carte électronique à une unité de commande électronique apte à émettre des ordres de commande pour commander l'orientation de chaque micro-miroir. La carte électronique comprend une première surface 21 en appui contre la puce, contre la première cale et contre la deuxième cale. La carte électronique comprend également une deuxième surface 22 opposée à la première surface 21.

Le support 30 est une structure supportant la carte électronique 20. Avantageusement, la position du support 30 est bien définie au sein du projecteur 1, et notamment par rapport à la position de la source lumineuse 2. Notamment, le support 30 peut être rigidement fixé au boîtier 4 du projecteur. A cet effet, le support 30 peut comprendre des moyens de fixation aptes à coopérer avec le boîtier. En variante, le support pourrait même former une seule et même pièce avec le boîtier 4 du projecteur. Le support 30 peut être un élément monobloc, par exemple fabriqué en matière plastique injecté. Par exemple, le support peut être fabriqué en polyéthersulphone avec 20 % de fibres de verre (PES GF20).

Le support 30 comprend une première surface 31 en appui contre la deuxième surface 12 de la puce, une deuxième surface 32 en appui contre la première cale 40, et une troisième surface 33 en appui contre la deuxième cale 50. La première surface 31 du support est sensiblement positionnée entre la deuxième surface 32 du support et la troisième surface 33 du support. Autrement dit, la deuxième surface 32 et la troisième surface 33 sont positionnées de part et d'autre de la première surface 31.

La première surface 31 peut être répartie en deux zones 31A, 31B distinctes l'une de l'autre et s'étendant le long de deux bords opposés de la deuxième surface 12 de la puce. En variante, la première surface peut comprendre une seule zone continue s'étendant à la périphérie de la première surface. En variante, la première surface 31 pourrait comprendre toute forme apte à fournir un appui à la puce 10. La première surface 31 est en appui contre une surface de référence de la puce. Lors de la construction de la puce 10, la position de cette surface de référence est positionnée avec une précision adéquate par rapport à la matrice de micro-miroirs 13. La première surface 31 du support, la première surface 11 de la puce 10, la deuxième surface 12 de la puce 10, la première surface 21 de la carte électronique 20, la deuxième surface 12 de la carte électronique 20 sont sensiblement parallèles entre elles.

Le support comprend en outre des moyens d'indexation 34 de la position de la puce par rapport au support. Ces moyens d'indexation peuvent se présenter sous la forme d'un ou plusieurs plots saillants en direction de la puce et coopérant avec une ouverture conjuguée pratiquée sur la deuxième surface de la puce. De plus, le support comprend une ouverture centrale 35 positionnée en vis-à-vis de la matrice de micro-miroirs 13. Une lentille transparente ou une vitre de protection peut être montée dans cette ouverture centrale 35 pour protéger la matrice de micro-miroirs.

Comme cela apparaît sur la figure 2, la deuxième surface 32 du support est inclinée par rapport à la première surface 31 du support. Plus précisément, la deuxième surface 32 s'étend selon un plan incliné s'étendant vers l'intérieur du module optique et vers la carte électronique 20. La première surface 31 du support peut former avec la deuxième surface 32 du support un angle A1 qui est défini à l'intérieur du cône de frottement défini par le coefficient de friction entre le support et la cale.

De même, la troisième surface 33 du support est inclinée par rapport à la première surface du support. La troisième surface 33 du support peut être symétrique par rapport à la deuxième surface suivant un plan perpendiculaire à la première surface 31. La première surface 31 du support peut également former avec la troisième surface 33 du support un angle compris entre A° et B° inclus, notamment compris entre C° et D° inclus, éventuellement égale à l'angle A1. La deuxième surface 32 et la troisième surface peuvent être inclinée dans des directions différentes, comme cela apparait sur la figure 1, ou en variante, dans des directions identiques.

La première cale 40 et la deuxième cale 50 peuvent être identiques ou symétriques l'une par rapport à l'autre. On s'attache donc à décrire la première cale 40 ainsi que son interface avec la carte électronique et le support. La première cale 40, que l'on pourrait également dénommer "coin", est un élément du module optique interposé entre le support 30 et la carte électronique 20. La cale 40 est une pièce distincte du support 30. Elle comprend une première surface 41 en appui contre la première surface 21 la carte électronique 20 et une deuxième surface 42 en appui contre la deuxième surface 32 du support 30. La première surface 41 forme avec la deuxième surface 42 un angle égal à l'angle A1 formé entre la première surface 31 du support et la deuxième surface 32 du support. Par conséquent, la première surface 41 s'étend dans un plan sensiblement parallèle au plan dans lequel s'étend la carte électronique 20.

Le support 30 n'est pas en contact avec la carte électronique mais il est lié à la carte électronique d'une part, par l'intermédiaire de la puce 10 et d'autre part, par l'intermédiaire des deux cales 40 et 50. En variante, le module optique pourrait comprendre une unique cale ou bien trois ou encore d'avantage de cales.

La cale 40 comprend en outre une ouverture traversante 43 orientée sensiblement perpendiculairement à la première surface 41. Le module optique comprend également une première vis de fixation 60 passant au travers d'un trou 24 dans la carte électronique 20, au travers de l'ouverture traversante 43 de la première cale 40, et enfin au travers d'une ouverture filetée 36 du support 10. D'un côté de la vis de fixation, une tête de vis 61 est en appui contre la deuxième surface 22 de la carte électronique 20. De l'autre côté de la vis de fixation, des filets de la vis de fixation 60 coopèrent avec l'ouverture filetée 36 conjuguée et pratiquée dans le support 30. Ainsi, la première vis de fixation 60 permet de serrer la carte électronique 20 sur la cale, et la cale sur le support. La première vis de fixation permet donc de bloquer en position la première cale par rapport au support par serrage de ses surfaces 41, 42. Une deuxième vis de fixation 70 coopère de manière identique avec la deuxième cale 50. La première vis 60 et la deuxième vis 70 constituent donc deux points de fixation de la carte électronique au support.

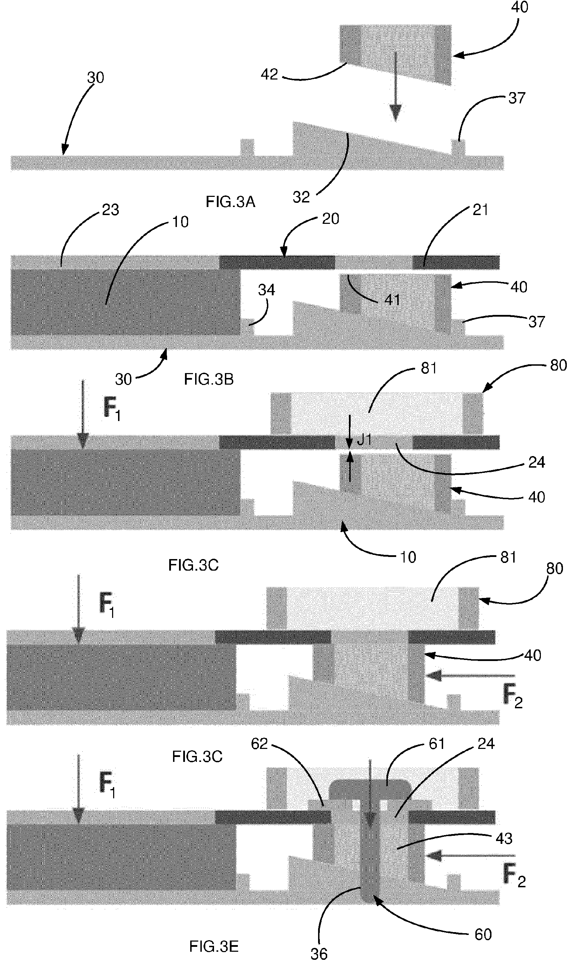

On s'attache à présent à décrire un mode de réalisation selon l'invention d'un procédé de fabrication du module optique. Le procédé de fabrication est notamment illustré sur les figures 3A à 3E illustrant cinq étapes successives de montage. En remarque, seule une partie du module optique 3 apparait sur ces figures, ne dévoilant ainsi que l'utilisation d'une seule cale, que l'on considère être la cale 40. Le montage d'un module optique comprenant deux cales ou davantage de cales peut bien sûr être obtenu en effectuant les mêmes opérations, aux mêmes moments, avec les autres cales. Lors du montage le support 30 pourra être orienté de telle sorte que la première surface 31 du support soit horizontale et tournée vers le haut. Une fois le module optique assemblé, les éléments sont rigidement fixés les uns aux autres et le module optique pourrait être intégré selon n'importe qu'elle orientation dans le projecteur 1.

Dans un première étape E1, illustrée sur la figure 3A, on apporte un support 30. Celui-ci est positionné horizontalement, c'est-à-dire de sorte que sa première surface 31 s'étende horizontalement. On apporte également la cale 40 et on la positionne sur le support de sorte que sa deuxième surface 42 soit en appui contre la deuxième surface 32 du support. En remarque, on distingue que le support 30 comprend avantageusement une butée 37 agencée à une extrémité de la deuxième surface 32, notamment en contrebas de la deuxième surface. Cette butée 37 est un moyen de retenue de la cale 40, préalablement à sa fixation définitive avec la vis de fixation 60. La butée 37 est apte à empêcher un glissement, sous l'effet de la gravité, de la première cale 40 hors de la deuxième surface du support. De même, le support peut comprendre une deuxième butée (non représentée) agencée à une extrémité de la troisième surface du support. La deuxième butée est apte à empêcher un glissement la deuxième cale hors de la troisième surface du support.

Dans une deuxième étape E2, illustrée sur la figure 3B, on positionne un ensemble formé par la carte électronique 20 et la puce 10 en appui sur la première surface 31 du support 30. En remarque, la puce 10 est assemblée (par exemple soudée ou enfichée) à la carte électronique 20 lors d'une étape préalable d'assemblage. A l'issue de l'étape préalable d'assemblage, la puce est fixée à la carte électronique selon des tolérances de positionnement données. L'ensemble est positionné de sorte à ce que les moyens d'indexation 34 du support coopèrent avec la puce 10. Ainsi, la puce trouve une position unique définie en référence au support 30. Afin de s'assurer que la puce est bien plaquée contre le support, une pression peut être appliquée sur la première surface 11 de la puce par exemple via l'ouverture 23 dans la carte électronique. La pression peut également être exercée via le dissipateur thermique si celui-ci est déjà assemblé à la puce. A l'issue de cette étape, la puce 10 est donc en appui contre la première surface du support 30. La cale 40 est en appui contre la deuxième surface du support et contre la butée 37. La carte électronique 20 est encore sans contact avec la cale 40. C'est-à-dire qu'il existe un jeu J1 non nul séparant la première surface 41 de la cale de la première surface 21 de la carte électronique 20. La taille du jeu J1 dépend notamment des tolérances de fabrication du support, de la puce et de la carte électronique.

Dans une troisième étape E3, illustrée sur la figure 3C, on positionne une pièce d'ouillage 80 au-dessus de la carte électronique, contre la deuxième surface 22 de la carte électronique. La pièce d'outillage 80 n'est pas un élément du module optique 3 mais un élément utile uniquement au procédé de fabrication du module optique. Notamment, elle permet d'empêcher toute déformation vers le haut de la carte électronique lors des étapes ultérieures du procédé. Autrement dit, elle permet de brider la carte électronique. La pièce d'outillage 80 peut présenter une ouverture traversante 81 et elle peut être positionnée de sorte à ce que l'ouverture traversante 81 soit centrée autour du trou 24 pratiqué dans la carte électronique. Lors de cette étape et jusqu'à la fin du procédé de fabrication un effort vertical F1 peut être appliqué de haut en bas sur la puce 10 (ou sur son dissipateur thermique) de manière à s'assurer qu'elle conserve bien le contact contre la première surface 31 du support.

Dans une quatrième étape E4, illustrée sur la figure 3D, on déplace la cale 40 le long de la deuxième surface 32 du support. La cale est poussée dans une direction qui provoque un déplacement en translation de la cale vers le haut. Compte-tenu de l'orientation de la deuxième surface 32 une poussée F2 orientée de l'extérieur vers l'intérieur du module est adaptée. Un vérin ou un opérateur peut réaliser cette poussée. En remarque la pente selon laquelle la deuxième surface est inclinée pourrait être orientée selon n'importe qu'elle direction. Toutefois, la direction qui est illustrée dans le mode de réalisation décrit permet une manipulation aisée de la cale puisque celle-ci peut être manipulée depuis un côté latéral du module. La cale 40 est donc poussée le long de la deuxième surface jusqu'à ce qu'elle vienne en appui contre la première surface 21 de la carte électronique 20. Comme la pièce d'outillage 80 est en appui sur la deuxième surface 22 de la carte électronique 20, l'effort appliqué par la cale 40 sur la carte électronique ne provoque pas de déformation de la carte électronique.

Avantageusement, l'angle A1 est assez important pour offrir une amplitude de positionnement de la cale 40 par rapport au support 30 suffisante. L'angle A1 est également suffisamment faible pour empêcher un éventuel glissement ultérieur de la cale 40, qui perdrait alors le contact soit avec la carte électronique 20, soit avec le support 30. Ainsi, l'angle A1 peut être défini pour être inférieur à l'angle d'un cône de frottement entre la cale 40 et le support 30. L'angle du cône de frottement dépend du coefficient d'adhérence entre la deuxième surface 42 de la cale 40 et la deuxième surface 32 du support 30. Par conséquent, les états de surface et les matériaux utilisés pour la fabrication de la calle et du support pourront être avantageusement choisis pour obtenir un coefficient d'adhérence suffisant.

Dans une cinquième étape E5, illustrée sur la figure 3E, on visse la vis de fixation 60 au travers du trou 24, au travers de l'ouverture traversante 43 et au travers de l'ouverture filetée 36. Avantageusement, l'ouverture traversante 43 est suffisamment large pour que la vis de fixation passe au travers de cette ouverture, sans contact avec la cale 40, quelle que soit la position de la cale 40. L'ouverture traversante 43 peut se présenter par exemple sous la forme d'une fente ou d'une ouverture oblongue orientée dans le sens dans lequel la cale est susceptible d'être déplacée. La vis de fixation 60 peut également passer au travers de l'ouverture traversante 81 de la pièce d'outillage 80.

La tension appliquée par la vis de fixation 60 permet de garder le support 30, la cale 40 et la carte électronique 20 bien en appui les uns contre les autres. Une rondelle 62 peut être prévue à l'interface entre la tête de vis 61 et la deuxième surface 22 de la carte électronique 20. Comme l'angle A1 est défini à l'intérieur du cône de frottement défini par le coefficient de friction entre le support et la cale, il n'y a pas de risque que la cale bouge une fois que la vis de fixation 60 est serrée. Dès lors, il est possible de relâcher les effort F1 et F2 appliqués respectivement sur la puce 10 et sur la cale 40. On peut également retirer la pièce d'outillage 80

Grâce au procédé de fabrication qui vient d'être décrit, on parvient à assembler simplement un module optique de sorte à ce que la puce prenne une position unique définie en référence au support. Notamment, le procédé ne requiert pas l'utilisation de colle ce qui est avantageux car la mise en oeuvre de colle dans un procédé d'assemblage est délicate. La carte électronique solidaire de la puce est également fixée au support sans contrainte additionnelle ni déformation. La fixation de l'ensemble formé par la carte électronique et la puce au support est une fixation isostatique. Par la suite, lors de l'utilisation du module optique, la position de la puce ne risque pas d'être perturbée par des contraintes qui auraient pu être transmises par la carte électronique. De plus, l'absence de contrainte dans la carte électronique empêche un vieillissement prématuré de la carte électronique. La fiabilité du module optique est ainsi améliorée. L'invention pourra être mise en oeuvre pour la fabrication de tout module optique comprenant une puce fixée à une carte électronique et dont le positionnement au sein du module optique doit être très précis.

## Revendications

1. Module optique (3) comprenant un support (30), une carte électronique (20), une puce (10) électronique et au moins une cale (40), la puce (10) étant fixée à la carte électronique (20), le support (30) comprenant une première surface (31) en appui contre la puce (10) et une deuxième surface (32) en appui contre l'au moins une cale (40), l'au moins une cale (40) étant en appui contre la carte électronique (20), le module optique (3) **caractérisé en ce que** la puce (1) électronique est munie d'une matrice de micro-miroirs (13) et la deuxième surface (32) du support (30) est inclinée par rapport à la première surface (31) du support (30).

2. Module optique (3) selon la revendication précédente, **caractérisé en ce qu'**il comprend au moins une deuxième cale (50), et **en ce que** le support (30) comprend une troisième surface (33) en appui contre l'au moins deuxième cale (50), la troisième surface (33) du support (30) étant inclinée par rapport à la première surface (31) du support (30), l'au moins deuxième cale (50) étant en appui contre la carte électronique (20).

3. Module optique (3) selon la revendication précédente, **caractérisé en ce que** la première surface (31) du support (30) est sensiblement positionnée entre la deuxième surface (32) du support (30) et la troisième surface (33) du support (30).

4. Module optique (3) selon l'une des revendication précédente, **caractérisé en ce qu'**il comprend au moins une vis de fixation (60) passant au travers de la carte électronique (20), de l'au moins une cale (40) et du support (30), de sorte à bloquer en position la cale (40) par rapport au support (30).

5. Module optique (3) selon l'une des revendication précédente, **caractérisé en ce que** le support (30) comprend un moyen d'indexation (34) de la position de la puce (10) par rapport au support (30), et/ou **en ce que** le support (30) comprend une butée (37) agencée à une extrémité de la deuxième surface (32) du support (30), la butée (37) étant apte à empêcher un glissement de l'au moins une cale (40) hors de la deuxième surface (32) du support (30).

6. Module optique (3) selon l'une des revendication précédente, **caractérisé en ce que** la carte électronique (20) s'étend selon un plan sensiblement parallèle à la première surface (31) du support (30).

7. Projecteur (1) pour un véhicule automobile, **caractérisé en ce qu'**il comprend au moins une source de lumière (2) et un module optique (3) selon l'une des revendications précédentes

8. Procédé de fabrication d'un module optique (3) selon l'une des revendication 1 à 6, **caractérisé en ce qu'**il comprend :
a. une étape de positionnement (E1) de l'au moins une cale (40) en appui contre la deuxième surface (32) du support (30),
b. une étape de positionnement (E2) de la puce (10) en appui contre la première surface (31) du support (30), la puce ayant été préalablement fixée à la carte électronique,
c. une étape de déplacement (E4) de l'au moins une cale (40) le long de la deuxième surface (32) du support (30) jusqu'à ce que l'au moins une cale (40) prenne appui contre la carte électronique (20).

9. Procédé de fabrication selon la revendication précédente, **caractérisé en ce qu'**il comprend une étape de vissage (E5) d'une vis de fixation (60) au travers de la carte électronique (20), de l'au moins une cale (40) et du support (30), de sorte à bloquer en position l'au moins une cale (40) par rapport au support (30).

10. Procédé de fabrication selon l'une des revendications 8 ou 9, **caractérisé en ce qu'**il comprend une étape de compression de la puce (10) contre le support (30) lors de l'étape de déplacement (E4) de l'au moins une cale (40) le long de la deuxième surface (32) du support (30), et éventuellement lors de l'étape de vissage (E5) de la vis de fixation (60).

11. Procédé de fabrication selon l'une des revendications 8 à 10, **caractérisé en ce qu'**il comprend une étape de positionnement (E3) d'une pièce d'outillage (80) contre la carte électronique (20), de sorte à empêcher une déformation de la carte électronique (20) sous l'effet d'un appui de l'au moins une cale (40) contre la carte électronique (20), lors de l'étape de déplacement (E4) de l'au moins une cale (40) le long de la deuxième surface (32) du support (30), et éventuellement lors de l'étape de vissage (E5) de la vis de fixation (60).

## Patentansprüche

1. Optisches Modul (3), umfassend einen Träger (30), eine Elektronikkarte (20), einen elektronischen Chip (10) und mindestens einen Keil (40), wobei der Chip (10) an der Elektronikkarte (20) befestigt ist, wobei der Träger (30) eine erste Fläche (31) umfasst, die in Anlage an dem Chip (10) ist, und eine zweite Fläche (32) in Anlage an dem mindestens einen Keil (40), wobei der mindestens eine Keil (40) in Anlage an der Elektronikkarte (20) ist, wobei das optische Modul (3) **dadurch gekennzeichnet ist, dass** der elektronische Chip (1) mit einem Mikrospiegel-Array (13) versehen ist und die zweite Fläche (32) des Trägers (30) in Bezug auf die erste Fläche (31) des Trägers (30) geneigt ist.

2. Optisches Modul (3) nach dem vorhergehenden Anspruch, **dadurch gekennzeichnet, dass** es mindestens einen zweiten Keil (50) umfasst und dass der Träger (30) eine dritte Fläche (33) in Anlage an dem mindestens einen zweiten Keil (50) umfasst, wobei die dritte Fläche (33) des Trägers (30) in Bezug auf die erste Fläche (31) des Trägers (30) geneigt ist, wobei der mindestens eine zweite Keil (50) in Anlage an der Elektronikkarte (20) ist.

3. Optisches Modul (3) nach dem vorhergehenden Anspruch, **dadurch gekennzeichnet, dass** die erste Fläche (31) des Trägers (30) im Wesentlichen zwischen der zweiten Fläche (32) des Trägers (30) und der dritten Fläche (33) des Trägers (30) positioniert ist.

4. Optisches Modul (3) nach einem der vorhergehenden Ansprüche, **dadurch gekennzeichnet, dass** es mindestens eine Befestigungsschraube (60) umfasst, die durch die Elektronikkarte (20), den mindestens einen Keil (40) und den Träger (30) hindurch verläuft, so dass der Keil (40) in Bezug auf den Träger (30) lagearretiert wird.

5. Optisches Modul (3) nach einem der vorhergehenden Ansprüche, **dadurch gekennzeichnet, dass** der Träger (30) ein Indexierungsmittel (34) zum Indexieren der Lage des Chips (10) in Bezug auf den Träger (30) umfasst, und/oder dass der Träger (30) einen Anschlag (37) umfasst, der an einem Ende der zweiten Fläche (32) des Trägers (30) angeordnet ist, wobei der Anschlag (37) geeignet ist, ein Gleiten des mindestens einen Keils (40) aus der zweiten Fläche (32) des Trägers (30) heraus zu verhindern.

6. Optisches Modul (3) nach einem der vorhergehenden Ansprüche, **dadurch gekennzeichnet, dass** sich die Elektronikkarte (20) entlang einer Ebene erstreckt, die im Wesentlichen parallel zu der ersten Fläche (31) des Trägers (30) ist.

7. Scheinwerfer (1) für ein Kraftfahrzeug, **dadurch gekennzeichnet, dass** er mindestens eine Lichtquelle (2) und ein optisches Modul (3) nach einem der vorhergehenden Ansprüche umfasst.

8. Verfahren zur Herstellung eines optischen Moduls (3) nach einem der Ansprüche 1 bis 6, **dadurch gekennzeichnet, dass** es umfasst:
a. einen Schritt des Positionierens (E1) des mindestens einen Keils (40) in Anlage an der zweiten Fläche (32) des Trägers (30),
b. einen Schritt des Positionierens (E2) des Chips (10) in Anlage an der ersten Fläche (31) des Trägers (30), wobei der Chip zuvor an der Elektronikkarte befestigt wurde,
c. einen Schritt des Verlagerns (E4) des mindestens einen Keils (40) entlang der zweiten Fläche (32) des Trägers (30), bis der mindestens eine Keil (40) an der Elektronikkarte (20) zur Anlage kommt.

9. Verfahren zur Herstellung nach dem vorhergehenden Anspruch, **dadurch gekennzeichnet, dass** es einen Schritt des Schraubens (E5) einer Befestigungsschraube (60) durch die Elektronikkarte (20), den mindestens einen Keil (40) und den Träger (30) hindurch umfasst, so dass der mindestens ein Keil (40) in Bezug auf den Träger (30) lagearretiert wird.

10. Verfahren zur Herstellung nach einem der Ansprüche 8 oder 9, **dadurch gekennzeichnet, dass** es einen Schritt des Pressens des Chips (10) gegen den Träger (30) bei dem Schritt des Verlagerns (E4) des mindestens einen Keils (40) entlang der zweiten Fläche (32) des Trägers (30) und gegebenenfalls bei dem Schritt des Schraubens (E5) der Befestigungsschraube (60) umfasst.

11. Verfahren zur Herstellung nach einem der Ansprüche 8 bis 10, **dadurch gekennzeichnet, dass** es einen Schritt des Positionierens (E3) eines Werkzeugteils (80) an der Elektronikkarte (20) umfasst, so dass eine Verformung der Elektronikkarte (20) unter der Einwirkung eines Drückens des mindestens einen Keils (40) gegen die Elektronikkarte (20) bei dem Schritt des Verlagerns (E4) des mindestens einen Keils (40) entlang der zweiten Fläche (32) des Trägers (30) und gegebenenfalls bei dem Schritt des Schraubens (E5) der Befestigungsschraube (60) umfasst.

## Claims

1. Optical module (3) comprising a support (30), an electronic board (20), an electronic chip (10) and at least one wedge (40), the chip (10) being fastened to the electronic board (20), the support (30) comprising a first surface (31) bearing against the chip (10) and a second surface (32) bearing against the at least one wedge (40), the at least one wedge (40) bearing against the electronic board (20), the optical module (3) being **characterized in that** the electronic chip (1) is provided with a micro-mirror array (13) and the second surface (32) of the support (30) is inclined with respect to the first surface (31) of the support (30).

2. Optical module (3) according to the preceding claim, **characterized in that** it comprises at least one second wedge (50), and **in that** the support (30) comprises a third surface (33) bearing against the at least one second wedge (50), the third surface (33) of the support (30) being inclined with respect to the first surface (31) of the support (30), the at least one second wedge (50) bearing against the electronic board (20).

3. Optical module (3) according to the preceding claim, **characterized in that** the first surface (31) of the support (30) is substantially positioned between the second surface (32) of the support (30) and the third surface (33) of the support (30).

4. Optical module (3) according to one of the preceding claims, **characterized in that** it comprises at least one fastening screw (60) passing through the electronic board (20), the at least one wedge (40) and the support (30), so as to block the wedge (40) in position with respect to the support (30).

5. Optical module (3) according to one of the preceding claims, **characterized in that** the support (30) comprises a means (34) for indexing the position of the chip (10) with respect to the support (30), and/or **in that** the support (30) comprises a stop (37) arranged at one end of the second surface (32) of the support (30), the stop (37) being able to prevent the at least one wedge (40) from sliding off the second surface (32) of the support (30) .

6. Optical module (3) according to one of the preceding claims, **characterized in that** the electronic board (20) extends in a plane substantially parallel to the first surface (31) of the support (30).

7. Headlight (1) for an automotive vehicle, **characterized in that** it comprises at least one light source (2) and one optical module (3) according to one of the preceding claims.

8. Method for manufacturing an optical module (3) according to one of Claims 1 to 6, **characterized in that** it comprises:
a. a step (E1) of positioning the at least one wedge (40) bearing against the second surface (32) of the support (30),
b. a step (E2) of positioning the chip (10) bearing against the first surface (31) of the support (30), the chip having been previously fastened to the electronic board,
c. a step (E4) of moving the at least one wedge (40) along the second surface (32) of the support (30) until the at least one wedge (40) bears against the electronic board (20).

9. Manufacturing method according to the preceding claim, **characterized in that** it comprises a step (E5) of screwing a fastening screw (60) through the electronic board (20), the at least one wedge (40) and the support (30), so as to block the at least one wedge (40) in position with respect to the support (30).

10. Manufacturing method according to either of Claims 8 and 9, **characterized in that** it comprises a step of compressing the chip (10) against the support (30) during the step (E4) of moving the at least one wedge (40) along the second surface (32) of the support (30), and optionally during the step (E5) of screwing the fastening screw (60).

11. Manufacturing method according to one of Claims 8 to 10, **characterized in that** it comprises a step (E3) of positioning a tooling piece (80) against the electronic board (20), so as to prevent deformation of the electronic board (20) under the effect of the at least one wedge (40) bearing against the electronic board (20), during the step (E4) of moving the at least one wedge (40) along the second surface (32) of the support (30), and optionally during the step (E5) of screwing the fastening screw (60).
